# EUROPEAN PATENT APPLICATION

(11) **EP 2 840 607 A1**
(43) Date of publication of application: **25.02.2015**
(21) Application number: 13181310.7
(22) Date of filing: 22.08.2013
(51) Int. Cl.: H01L 25/07, H01L 23/373, H01L 23/538

(54) **Semiconductor module**

(71) Applicant: ABB Technology AG, 8050 Zürich (CH)
(72) Inventor: Riedel, Gernot, 5406 Baden-Rütihof (CH); Schulz, Nicola, 5300 Turgi (CH); Kicin, Slavo, 8049 Zürich (CH)
(74) Representative: ABB Patent Attorneys

(57) **Abstract**

A semiconductor module (10a) is proposed, which comprises a base plate (12) and a first insulating ceramics substrate plate (14, 14a, 14b), which is at least partially covered with a metallization layer (16, 16') and which carries at least one semiconductor chip (18) and which is mounted to the base plate (12). The semiconductor chip (18) may for instance be a high-power semiconductor chip. The semiconductor module (10) further comprises a second insulating ceramics substrate plate (20), which is at least partially covered with a metallization layer (22, 22') and which is directly or indirectly mounted to the base plate (12). The first substrate plate (14, 14a, 14b) is manufactured from a first ceramics material and the second substrate plate (20) is manufactured from a second ceramics material, which may be different from the first ceramics material.

## Description

### FIELD OF THE INVENTION

The invention relates to semiconductor modules and a method for producing such modules.

### BACKGROUND OF THE INVENTION

In semiconductor modules usually a plurality of semiconductor chips as well as various other components, such as e.g. resistors, capacitors, electrical connectors and terminals (electrodes), are together mounted on a metallization layer of an insulating ceramics substrate plate.

The concept of mounting the components and semiconductor chips together on a single and consequently rather large substrate plate may lead to certain disadvantages for example in terms of a production yield, reliability and it may make an introduction of novel techniques for bonding module parts, such as e.g. semiconductor chips and terminals, to the substrate plates and/or the substrate plates to the base plate rather challenging.

### DESCRIPTION OF THE INVENTION

It is an objective of the invention to provide a robust and reliable semiconductor module at low production costs.

This objective is achieved by the subject-matter of the independent claims. Further exemplary embodiments are evident from the dependent claims and the following description.

An aspect of the invention relates to a semiconductor module, for example a high-power semiconductor module. The term "high-power" in this context may mean that a high-power semiconductor module may be adapted for processing a current above about 10 A and/or a voltage above 1000 V.

According to an embodiment of the invention, the semiconductor module comprises a base plate and a first insulating ceramics substrate plate carrying at least one semiconductor chip, which first substrate plate is mounted to the base plate. The at least one semiconductor chip may be a high-power semiconductor chip, such as for instance an IGBT, a MOSFET, a diode, a thyristor or a BiGT. Also various semiconductor chips of different types may be assembled in a semiconductor module. The semiconductor module further comprises a second insulating ceramics substrate plate, which is directly or indirectly mounted to the base plate.

According to an embodiment of the invention, the first substrate plate is manufactured from a first ceramics material and the second substrate plate is manufactured from a second ceramics material different from the first ceramics material.

Using substrate plates manufactured from different ceramics materials may allow exploiting different material characteristics, and consequently may increase flexibility of the production of the semiconductor module. For example, for the first substrate plate carrying the semiconductor chips, a (first) ceramics material with a high thermal conductivity may be advantageous, since lower thermal resistance allows dissipation of more heat generated by semiconductor chips and thus higher current density. For the other components of the semiconductor module a high thermal conductivity of the substrate material may not necessarily be required, but a mechanically robust and low-cost (second) material may be feasible.

On the second substrate plate various other components of the semiconductor module, such as e.g. resistors, capacitors and/or terminals (electrodes) for electrically connecting the semiconductor module, may be mounted. However, also on the first substrate plate other components may be mounted apart from the semiconductor chips.

However, the semiconductor module may comprise several base plates, each of which may carry the first and second substrate plate. Even the different substrate plates, i.e. the first and second substrate plate, may be mounted on different base plates. For example the semiconductor module may comprise one base plate carrying the semiconductor chips (maybe integrated base plate) and one base plate carrying the terminals.

The first and/or second insulating ceramics substrate plates may be at least partially covered with an electrically conductive metallization layer, such as for instance a layer of Cu, Al, or an alloy. The metallization layer may optionally be finished with Ni, Ag, Au, or any other electrically conductive material or alloy. In other words, the first and/or second insulating ceramics substrate plates may further comprise a metallization layer on one or on both sides of each substrate plate, wherein the metallization layer may at least partially cover a side of the respective substrate plate. The metallization layer may facilitate mounting and bonding of the semiconductor chips, terminals and other components on the substrate plates. Moreover, it may facilitate bonding the first and second substrate plate to the base plate or bonding the second substrate plate to the first substrate plate, for instance. Apart from that, the metallization layer may electrically connect components mounted on a single substrate plate, and it may serve for electrically connecting various substrate plates by electrically connecting the respective metallization layers.

The semiconductor chips may for instance be mounted to the first substrate plate and the corresponding metallization layer by soldering, sintering, transient liquid phase bonding and/or gluing. Also other components of the semiconductor module, such as the terminals, may be for example soldered, welded or mounted to the second substrate plate and the corresponding metallization layer using any other suitable technique. Mounting of the substrate plates e.g. to the base plate may again comprise soldering, sintering, transient liquid phase bonding, gluing and/or any other bonding technique similarly as bonding of the second substrate plate on the first substrate plate.

According to an embodiment of the invention, the first substrate plate and the second substrate plate are mounted in juxtaposition with each other to a side of the base plate. In other words, the first and second substrate plate may be mounted side by side to the base plate, thereby neighboring each other.

Substrate plates comprising both semiconductor chips and other components of the semiconductor module may be rather large (approximately 50x50 mm²). By using different substrate plates for mounting the semiconductor chips and other components of the semiconductor module, a size of the respective substrate plates may be reduced. Consequently, a joining area between substrate plates and base plate may be reduced, which may allow introduction of innovative and high performance bonding techniques for mounting the small-sized substrate plates to the base plate, such as for instance low-temperature bonding and transient liquid phase bonding, which techniques may be rather challenging when large-sized substrate plates are used.

A smaller substrate plate may have further advantages regarding its interconnection with the base plate. For instance, a mechanical stress in an interconnection layer between a substrate plate and the base plate under thermal cycling may be reduced. Hence, an interconnection and bonding reliability may be improved. Apart from that, due to the reduced mechanical stress and a feasibility to use novel interconnection and bonding techniques, such as e.g. low-temperature bonding and transient liquid phase bonding, also Cu base plates may be used instead of AlSiC base plates, which are usually used. This may further reduce production costs and may additionally reduce a thermal resistance of the base plate.

According to an embodiment of the invention, the first substrate plate is mounted with a first side to the base plate and the second substrate plate is mounted to a second side of the first substrate plate. In other words, the second substrate plate is mounted on top of or onto the first substrate plate. The first and the second substrate plate may be manufactured from different or the same insulating ceramics material, for example as described above and below.

According to an embodiment of the invention, the second substrate plate only covers a part of the first substrate plate. Accordingly, the first substrate plate may be larger in size than the second substrate plate mounted on top of the first.

The second substrate plate may be mounted to the first substrate plate such that the at least one semiconductor chip is not covered by the second substrate plate and, for example, not damaged during mounting the second substrate plate onto the first substrate plate.

According to an embodiment of the invention, the semiconductor module further comprises at least one terminal for electrically connecting the semiconductor module, which at least one terminal is mounted to the second substrate plate.

The terminals may serve to electrically connect the entire semiconductor module or a part of the semiconductor module. Hence, various current-carrying terminals may be mounted to the second substrate, for instance a collector and/or an emitter terminal, which may differ in electrical polarity. Also terminals for various types of current, such as AC and/or DC terminals may be mounted. The terminals may be manufactured from a metal material, such as e.g. Cu, , Al or any other electrically conductive material or alloy and eventually coated by another layer of metal to simplify an attach process of the terminals or improve a quality of the bond.

According to an embodiment of the invention, the first ceramics material is AlN and/or the second ceramics material is Al₂O₃ or Si₃N₄. Also combinations of these ceramics materials may be used for each substrate plates, and also both substrate plates may be made of the same ceramics material, i.e. AlN, Al₂O₃ or Si₃N₄.

With a high thermal conductivity, AlN may be well suited for the first substrate plate carrying the semiconductor chips, since the chips may generate excessive amounts of heat during operation. This may require a low thermal resistance for the substrate plate carrying the chips in order to effectively and quickly conduct heat from the chips to the base plate and e.g. to a heat sink.

On the other hand, Al₂O₃ and Si₃N₄ may be well suited for manufacturing the second substrate plate carrying e.g. the terminals due to a mechanical robustness of these materials. Hence, the second substrate plate may be unlikely to be damaged during mounting the terminals. Apart from that, Al₂O₃ is a rather cheap material, thus production costs may be saved. The thermal conductivity of Al₂O₃ and Si₃N₄ may not play a role since nearly no heat may be generated by the components mounted to the second substrate plate, such as the terminals. In general, the thermal conductivity of the first ceramics material may be better than the thermal conductivity of the second ceramics material.

According to an embodiment of the invention, the first substrate plate und the second substrate plate are electrically connected via a flexible connector. The flexible connector may for instance be a wire bond, a ribbon bond, or a flex print, which may be an electrically conductive sheet between two insulating sheets. Also the electrical components mounted to the substrate plates, such as e.g. the semiconductor chips, may be electrically connected with flexible connectors.

By connecting the first and second substrate plate as well as the electrical components with flexible connectors, any potential bending of the semiconductor module, the base plate and/or certain electrical components, for example due to heat expansion, may result in less mechanical stress within the substrates. Hence, a reliability may be enhanced compared to one large area substrate.

According to an embodiment of the invention, the semiconductor module further comprises at least one further first substrate plate, each further first substrate plate carrying at least one semiconductor chip.

Each of the first substrate plates may be connected to the second substrate plate. Therefore, a single second substrate plate, which may carry the terminals, may be connected to and serve several first substrate plates carrying the semiconductor chips. Consequently, the module may be produced in a compact form and costs may be reduced.

According to an embodiment of the invention, the semiconductor module comprises at least one further second substrate plate, each further second substrate plate carrying at least one further terminal.

The terminals mounted on the further second substrate plates may for instance be gate contacts or gate terminals for the semiconductor chips (i.e. connected to gate islands). Also auxiliary emitter and/or collector terminals may be mounted, which may serve e.g. for voltage sensing.

A further aspect of the invention relates to a method for manufacturing a semiconductor module. The method comprises the steps of providing a first insulating ceramics substrate plate from a first ceramics material, bonding a semiconductor chip to the first substrate plate. The method further comprises mounting the first substrate plate to a base plate, and directly or indirectly mounting the second substrate plate to the base plate.

The first and second substrate plates may be provided simultaneously or subsequently, and mounting the first and/or second substrate plate to the base plate may be carried out in arbitrary sequence. In contrast, it may be feasible to bond the semiconductor chip to the first substrate plate before the first substrate plate is mounted to the base plate, because production-inline electrical tests after bonding the semiconductor chips and before mounting the substrate plate to the base plate may be carried out on small-sized elements, e.g. on small substrate plates comprising three chips instead of on large substrate plates comprising six chips. This may improve a production yield since less material may be rejected, and consequently production costs may be reduced.

According to an embodiment of the invention, the method further comprises providing a second insulating ceramics substrate plate from a second ceramics material different from the first ceramics material. For example, the two substrate plates may be mounted side by side directly to the base plate.

According to an embodiment of the invention, the method further comprises mounting the first substrate plate with a first side to a base plate, and mounting the second substrate plate to a second side of the first substrate plate such that the first substrate plate is indirectly mounted to the base plate.

It may be feasible to mount the second substrate plate on top of the first substrate plate before mounting the first substrate plate to the base plate. This approach may allow testing electrical connections between both substrate plates and/or electrical connections between electrical components mounted on the two substrate plates in a comprehensive manner in order to ensure proper functioning of the components, electrical connections and the entire semiconductor module.

According to an embodiment of the invention, the method further comprises welding at least one terminal to the second substrate plate before the second substrate plate is mounted to the base plate or to the first substrate plate. The term "welding" may comprise ordinary welding and/or other welding techniques, in particular ultrasonic welding.

For instance, during ultrasonic welding of terminals to the second substrate plate, particles may be generated and may be scattered among the entire semiconductor module if the second substrate is already mounted to the base plate, which may be unwanted since it may lead to insulation breakdown during operation of the module. Particles inside the module may be prevented if the terminals are welded on the second substrate before it is put into/mounted to the module.

In order to properly weld the terminals to the substrate plate, a corresponding design of the terminals may be adapted, such as for instance pre-bending of terminal lashes.

According to an embodiment of the invention, the method further comprises gluing the second substrate plate to the base plate or to the first substrate plate, or bonding the second substrate plate to the base plate or to the first substrate plate. In other words, the second substrate plate may be glued or bonded to the base plate or to the first substrate plate.

The second substrate plate containing for example the terminals may be attached to the base plate or to the first substrate plate by a low-cost assembly process, such as e.g. gluing and/or low-temperature bonding, since a thermal resistance of the second substrate may not be of high importance, because no excessive amount of heat may be generated by the components mounted on the second substrate. Also nano low-temperature bonding powder may be advantageously used for bonding the second substrate plate to the base plate or to the first substrate plate.

According to an embodiment of the invention, the method further comprises bonding the first substrate plate to the base plate.

According to an embodiment of the invention, bonding of the second substrate to the base plate or the first substrate plate as well as bonding the first substrate plate to the base plate may comprise soldering, sintering, transient liquid phase bonding, gluing, and/or low-temperature bonding.

The first and the second substrate plates may be bonded applying the same bonding technique or applying different bonding techniques for each substrate plate, respectively. Also various bonding techniques may be combined for bonding a single substrate plate. Choosing from different bonding techniques and approaches may increase the flexibility of the production of the semiconductor module. Also the reliability of module may be enhanced since various bonding approaches may be applied for the substrate plates, which approaches may meet substrate plate specific requirements, e.g. concerning thermal conductivity and mechanical robustness.

It has to be understood that features of the method as described in the above and in the following may be features of the semiconductor module as described in the above and in the following.

If technically possible but not explicitly mentioned, also combinations of embodiments of the invention described in the above and in the following may be embodiments of the method and the semiconductor module.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig. 1 schematically shows a perspective view of a semiconductor module according to an embodiment of the invention.
Fig. 2 schematically shows a top view of a semiconductor module according to another embodiment of the invention.
Fig. 3 shows a flow chart schematically illustrating the steps of a method of producing the semiconductor modules of Fig. 1 or Fig. 2.
Fig. 4 schematically shows a perspective view of a semiconductor module according to another embodiment of the invention.
Fig. 5 schematically shows a perspective view of a semiconductor module according to another embodiment of the invention.
Fig. 6 shows a flow chart schematically illustrating the steps of a method of producing the semiconductor modules of Fig. 4 or 5.

In principle, identical parts are provided with the same reference symbols in the figures.

### DETAILED DESCRIPTION OF EXEMPLARY EMBODIMENTS

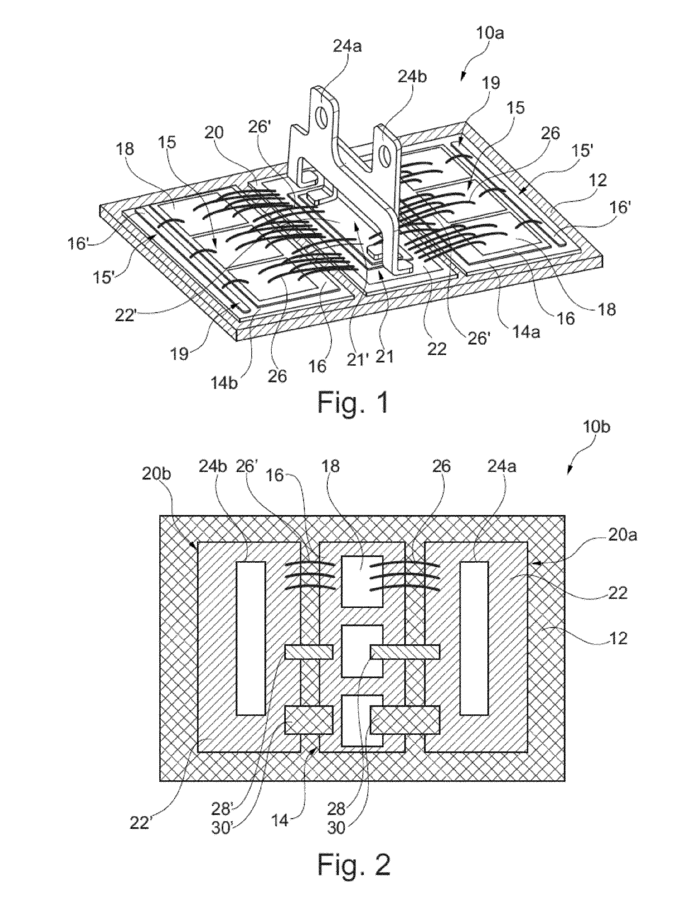

Fig.1 schematically shows a perspective view of a semiconductor module 10a. The semiconductor module 10a comprises a base plate 12 and two insulating ceramics substrate plates 14a, 14b mounted on a side of the base plate 12.

The base plate 12 may be manufactured from Cu or AlSiC, and the substrate plates 14a, 14b may be manufactured from AlN. The substrate plates 14a, 14b may be bonded to the base plate by soldering, transient liquid phase bonding or low-temperature bonding.

Each substrate plate 14a, 14b comprises a region 15 and a further region 15', which regions 15, 15' are covered with an electrically conductive metallization layer 16, 16', respectively. The metallization layers 16, 16' are arranged separated and electrically insulated from each other on each substrate plate 14a, 14b.

In region 15 of each substrate plate 14a, 14b, three semiconductor chips 18 are mounted on top of the metallization layer 16 in juxtaposition with each other, and a side of each chip 18 is in electrical contact with the metallization layer 16, e.g. by soldering the respective side of each chip 18 to the metallization layer 16. The semiconductor chips may be or may comprise for instance an IGBT, a MOSFET, a diode, a thyristor or a BiGT.

Each further region 15' of each substrate plate 14a, 14b may comprise a gate contact 19 for each semiconductor chip 18, respectively. Also terminals for sensing operational quantities of the semiconductor chips 18, such as e.g. a voltage, may be arranged in each region 15' of each substrate plate 14a, 14b.

The semiconductor module 10a comprises a further insulating ceramics substrate plate 20, which may be manufactured from Al₂O₃ or Si₃N₄. The substrate plate 20 is mounted between the substrate plates 14a, 14b on the base plate 12, i.e. the three substrate plates 14a, 14b, 20 are in juxtaposition with each other mounted side-by-side onto the base plate 12.

The substrate plate 20 may be glued or bonded to the base plate 12. Substrate plate 20 may for instance be bonded to the base plate 12 by soldering, transient liquid phase bonding, or low-temperature bonding.

The substrate plate 20 comprises a region 21 surrounding a further region 21', which regions 21, 21' are covered with an electrically conductive metallization layer 22, 22', respectively. The metallization layers 22, 22' are arranged separated and electrically insulated from each other the substrate plate 20.

In region 21 of substrate plate 20 a terminal 24a is mounted on top of the metallization layer 22, and in region 21' of substrate plate 20 a further terminal 24b is mounted on top of the metallization layer 22'. Each terminal 24a, 24b may be welded to the respective metallization layer 22, 22', e.g. by ultrasonic welding. The terminals 24a, 24b may be an emitter and a collector terminal serving as electrodes of the semiconductor module 10a.

Each semiconductor chip 18 is electrically connected with wire bonds 26 to the metallization layer 22 of substrate plate 20. Accordingly, each semiconductor chip 18 is in electrical contact with the terminal 24a welded to the metallization layer 22 of substrate plate 20. Apart from that, each metallization layer 16 of each substrate plate 14a, 14b is electrically connected with wire bonds 26' to the metallization layer 22' of substrate plate 20, which is in turn in electrical contact with the terminal 24b welded to the metallization layer 22' of substrate plate 20. Therefore, the terminals 24a, 24b are electrically connected to the electrical contacts of all semiconductor chips 18 of the semiconductor module 10.

Fig. 2 schematically shows a top view of a semiconductor module 10b. If not otherwise described, the semiconductor module 10b may have the same components and/or may be manufactured accordingly as the semiconductor module 10a.

The semiconductor module 10b comprises a single insulating ceramics substrate plate 14 with a metallization layer 16 mounted to the base 12.

The semiconductor module 10 comprises two further insulating ceramics substrate plates 20a, 20b with metallization layers 22, 22' and two terminals 24a, 24b welded to the metallization layers 22, 22', respectively. The substrate plates 14, 20a, 20b are mounted in juxtaposition with respect to each other onto the base plate 12.

On top of the substrate plate 14 three semiconductor chips 18 are mounted, which may be soldered to the substrate plate 14. The semiconductor chips 18 are electrically connected to the metallization layer 22 of substrate plate 20a, wherein one chip 18 is connected by wire bonds 26, one chip 18 is connected by a ribbon bond 28, and one chip 18 is connected by a flex print 30.

Moreover, the metallization layer 22' of substrate plate 20b, which carries the terminal 24b, is electrically connected to the metallization layer 16 of substrate plate 14 by wire bonds 26', a ribbon bond 28' and a flex print 30'.

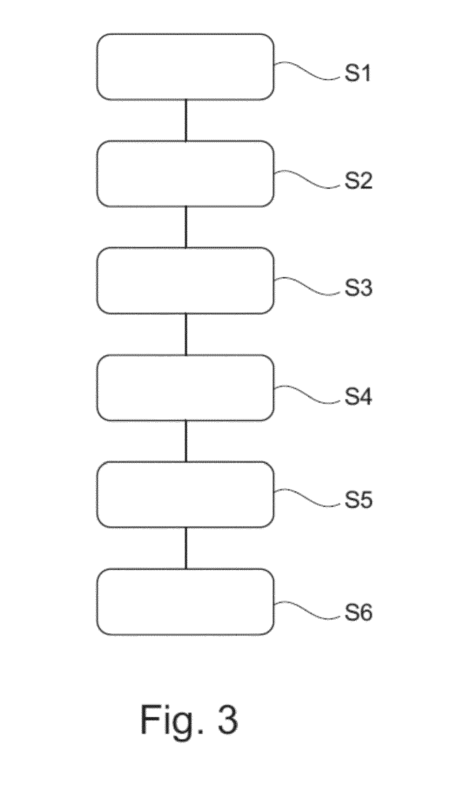

Fig. 3 shows a flow chart schematically illustrating the steps of a method of producing the semiconductor modules 10a, 10b of Fig. 1 or Fig. 2.

In a step S1, the method comprises providing a first insulating ceramics substrate plate 14 from a first ceramics material. The first ceramics material may for instance be AlN.

The first insulating ceramics substrate plate 14 may further be covered in step S1 with an electrically conductive metallization layer 16, 16', for instance by vapor deposition of an electrically conductive material, such as e.g. Cu, Al, or an alloy. Optionally, the metallization layer 16, 16' may be finished with Ni, Ag, Au, or any other electrically conductive material or alloy. However, the first insulating ceramics substrate plate 14 may already be provided with an electrically conductive metallization layer 16, 16' in step S1.

In a step S2 at least one semiconductor chip 18 is bonded to the first insulating ceramics substrate plate 14. The semiconductor chip 18 may for instance be soldered to the metallization layer 16, 16' in order to electrically connect the semiconductor chip 18.

The method further comprises a step S3 of providing a second insulating ceramics substrate plate 20 from a second ceramics material, which is different from the first ceramics material. The second ceramics material may for instance be Al₂O₃ or Si₃N₄.

The step S3 may further comprise covering the second substrate plate 20 with an electrically conductive metallization layer 22, 22', for instance by vapor deposition of an electrically conductive material, such as e.g. Cu, Al, or an alloy. Optionally, the metallization layer 22, 22' may be finished with Ni, Ag, Au, or any other electrically conductive material or alloy. However, the second insulating ceramics substrate plate 20 may already be provided with an electrically conductive metallization layer 22, 22' in step S3.

The first substrate plate 14 is mounted in a step S4 to a base plate 12 of the semiconductor module 10a, 10b, wherein the base plate 12 may for instance be manufactured from Cu or AlSiC. Mounting the first substrate plate 14 to the base plate 12 may further comprise bonding the first substrate plate 14 to the base plate 12. Therein, bonding of the first substrate plate 14 may comprise at least one of soldering, sintering, transient liquid phase bonding, or low-temperature bonding.

In a step S5 at least one terminal 24a, 24b is welded to the second substrate plate 20, for instance by ultrasonic welding.

Finally, in a step S6 the second substrate plate 20 is mounted to the base plate 12. Mounting of the second substrate plate 20 to the base plate may comprise gluing or bonding, wherein bonding may comprise at least one of soldering, sintering, transient liquid phase bonding, or low-temperature bonding.

The steps S2 and S4 may be carried out before step S1, and the steps S5 and S6 may be be carried out before step S3. On the other hand, the step S2 may be carried out before or after mounting the first substrate plate 14 to the base plate 12 in step S4. The step S3 may be carried out before or after the steps S1, S2 and S4, respectively. However, it may be advantageous to carry out the step S5 before the step S6 in order to avoid particles resulting from the welding process in step S5 to be present in the semiconductor module 10a, 10b.

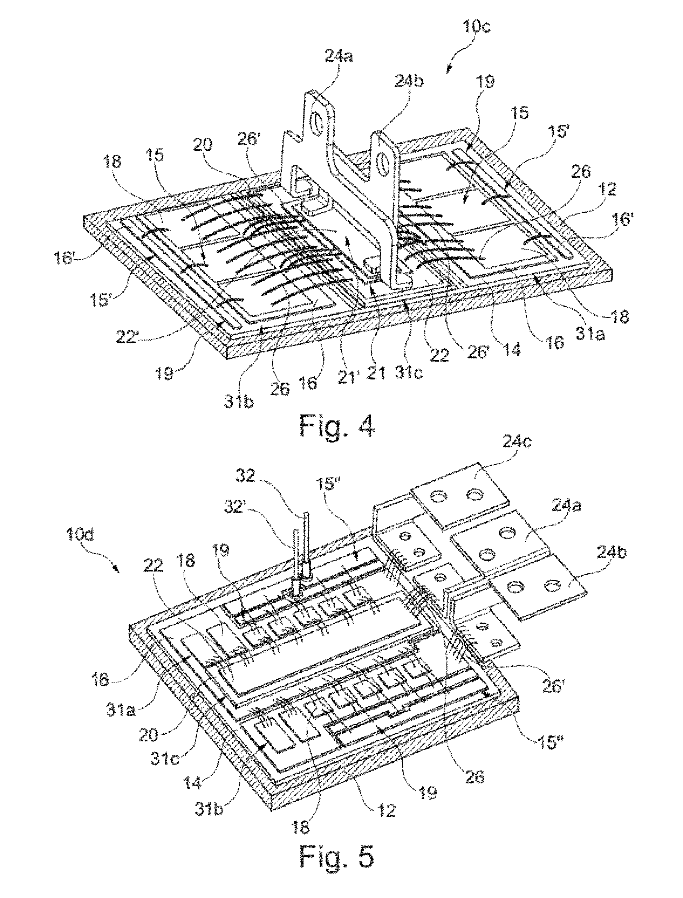

Fig. 4 schematically shows a perspective view of a semiconductor module 10c. If not otherwise described, the semiconductor module 10c may have the same components and/or may be manufactured accordingly as the semiconductor modules 10a, 10b.

In particular, all features of the semiconductor module 10c shown in Fig. 4 may be identical to the features of the semiconductor module 10a shown in Fig. 1, except the following:

The semiconductor module 10c in Fig. 4 comprises only a single, large-sized insulating ceramics substrate plate 14 mounted to the base plate 12 instead of two small-sized ones 14a, 14b as shown in Fig. 1. The substrate plate 14 may be bonded to the base plate 12 by soldering, transient liquid phase bonding or low-temperature bonding.

The large-sized substrate plate 14 comprises a first region 31a and a second region 31 b replacing the small-sized substrate plates 14a, 14b of Fig. 1 in terms of functionality and features contained thereon. Accordingly, the regions 31 a, 31 b of the large-sized substrate plate 14 each comprise a region 15 and a further region 15', which regions 15, 15' are covered with an electrically conductive metallization layer 16, 16', respectively. However, the regions 15, 15' may also be covered with a single metallization 16, i.e. a single metallization layer 16, may cover a first and/or second side of the entire substrate plate 14, or a single metallization layer 16 may cover the entire substrate plate 14. In each region 15 of each region 31 a, 31 b of substrate plate 14 three semiconductor chips 18 are mounted (e.g. soldered) on top of the metallization layer 16 in juxtaposition with each other. Hence, a side of each chip 18 is in electrical contact with the metallization layer 16.

Furthermore, the substrate plate 20 carrying the terminals 24a, 24b is mounted in a middle region 31 c of substrate plate 14 instead of on the base plate 12 as shown in Fig. 1. Therein, substrate plate 20 may be glued to the middle region 31 c of substrate plate 14 or bonded e.g. by soldering, sintering, transient liquid phase bonding, or low-temperature bonding.

Fig. 5 schematically shows a perspective view of a semiconductor module 10d according to another embodiment of the invention. If not otherwise described, the semiconductor module 10d may have the same components and/or may be manufactured accordingly as the semiconductor modules 10a, 10b, 10c.

Analogously to Fig. 4, the semiconductor module 10d comprises a large-sized insulating ceramics substrate plate 14, which is mounted to the base plate 12, and which is at least partially covered with the metallization layer 16.

The substrate plate 14 comprises a plurality of semiconductor chips 18, which may be soldered to the metallization layer 16 in juxtaposition with each other in regions 31a, 31 b of the substrate plate 14. The semiconductor chips 18 may be of different types, such as for instance an IGBT, a MOSFET, a diode, a thyristor or a BiGT.

Moreover, the substrate plate 14 comprises a region 15" and a further region 15", which regions 15" may comprise a plurality of gate contacts 19 for the semiconductor chips 18 and auxiliary terminals 32, 32', which may serve e.g. for voltage sensing.

The semiconductor module 10d further comprises a second insulating ceramics substrate plate 20 which is mounted to the substrate plate 14 in a middle region 31c of substrate plate 14. The substrate plate 20 is at least partially covered with a metallization layer 22.

Furthermore, the semiconductor module 10d comprises three terminals 24a, 24b, 24c, wherein terminal 24a is electrically connected with wire bonds 26 to the metallization layer 22 of substrate plate 20, and terminals 24b, 24c are electrically connected with wire bonds 26' to the metallization layer 16 of substrate plate 14. The terminals 24a, 24b may for instance be DC carrying terminals, whereas terminal 24c may for instance be an AC carrying terminal.

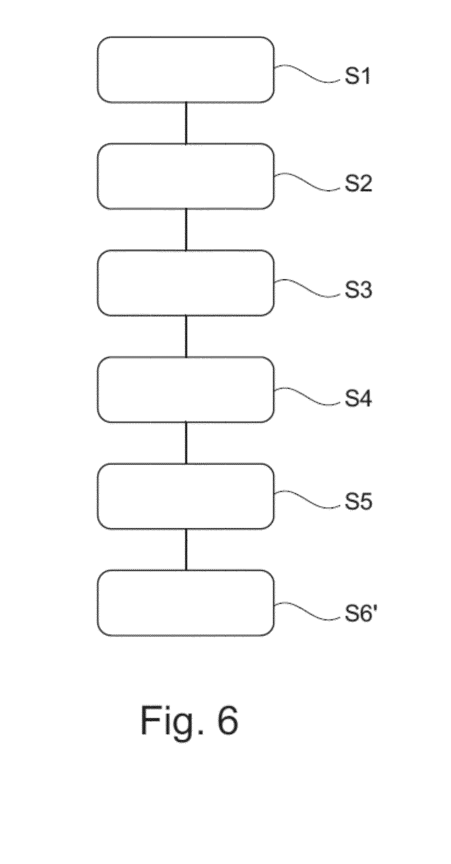

Fig. 6 shows a flow chart schematically illustrating the steps of a method of producing the semiconductor modules 10c, 10d of Fig. 5 and Fig. 6.

The steps S1, S2, S3, S4 and S5 may be identical to the corresponding steps described in Fig. 3, which are:

Providing a first insulating ceramics substrate plate 14 in step S1, bonding a semiconductor chip to the first substrate plate 14 in step S2, providing a second insulating ceramics substrate plate 20 in step S3, mounting the first substrate plate 14 with a first side to the base plate 12 in step S4, and welding at least one terminal 24a, 24b to the second substrate plate 20 in step S5.

The first insulating ceramics substrate plate 14 provided in step S1 and the second insulating ceramics substrate plate 20 provided in step S3 may be manufactured from the same ceramics material or may be manufactured from different ceramic materials. Potential ceramics materials may for instance be AlN, Al₂O₃ or Si₃N₄.

Finally, in a step S6' the second substrate plate 20 is mounted on a second side of the substrate plate 14 instead of on the base plate 12 as described in Fig. 3. The second substrate plate 20 is mounted on top of the first substrate plate 14 such that the semiconductor chip 18 is not covered by the second substrate plate 20.

Mounting the first substrate plate 14 to the base plate 12 and mounting the second substrate plate 20 to the first substrate plate 14 may comprise gluing or bonding, wherein bonding may comprise at least one of soldering, sintering, transient liquid phase bonding, or low-temperature bonding.

Also in the method of producing the semiconductor module 10c, 10d illustrated in Fig. 6, the steps S2 and S4 may be carried out before step S4, and the steps S5 and S6 may be carried before step S3. The step S2 may be carried out before or after mounting the first substrate plate 14 to the base plate 12 in step S4. The step S3 may be carried out before or after the steps S1, S2 and S4, respectively. However, it may be advantageous to carry out the step S5 before the step S6' in order to avoid particles resulting from the welding process in step S5 to be present in the semiconductor module 10.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### LIST OF REFERENCE NUMERALS

- 10a 10b, 10c, 10d: semiconductor module
- 12: base plate
- 14: ceramics substrate plate
- 14a: ceramics substrate plate
- 14b: ceramics substrate plate
- 15: region of substrate plate
- 15': further region of substrate plate
- 15": further region of substrate plate
- 16: metallization layer
- 16': metallization layer
- 18: semiconductor chip
- 19: gate contact
- 20, 20a, 20b: ceramics substrate plate
- 21: region of substrate plate
- 21': further region of substrate plate
- 22: metallization layer
- 22': metallization layer
- 24a: terminal
- 24b: terminal
- 24c: terminal
- 26, 26': wire bond
- 28, 28': ribbon bond
- 30, 30': flex print
- 31a: first region of ceramics substrate plate
- 31b: second region of ceramics substrate plate
- 31c: middle region of ceramics substrate plate
- 32: auxiliary terminal
- 32': auxiliary terminal
- S1: providing first substrate plate
- S2: bonding semiconductor chip
- S3: providing second substrate plate
- S4: mounting first substrate plate
- S5: welding terminal to second substrate plate
- S6: mounting second substrate plate
- S6': mounting second substrate plate

## Claims

1. A semiconductor module (10a, 10b, 10c, 10d), comprising:
a base plate (12);
a first insulating ceramics substrate plate (14, 14a, 14b), which is at least partially covered with a metallization layer (16, 16') and which carries at least one semiconductor chip (18) and which is mounted to the base plate (12);
a second insulating ceramics substrate plate (20), which is at least partially covered with a metallization layer (22, 22') and which is mounted to the base plate (12);
wherein the first substrate plate (14, 14a, 14b) is manufactured from a first ceramics material and the second substrate plate (20) is manufactured from a second ceramics material different from the first ceramics material.

2. The semiconductor module (10a, 10b, 10c, 10d) of claim 1,
wherein the first substrate plate (14, 14a, 14b) and the second substrate plate (20) are mounted in juxtaposition with each other to a side of the base plate (12).

3. A semiconductor module (10c, 10d), comprising:
a base plate (12);
a first insulating ceramics substrate plate (14, 14a, 14b), which is at least partially covered with a metallization layer (16, 16') and which carries at least one semiconductor chip (18) and which is mounted to the base plate (12);
a second insulating ceramics substrate plate (20), which is at least partially covered with a metallization layer (22, 22') and which is mounted to the base plate (12);
wherein the first substrate plate (14, 14a, 14b) is mounted with a first side to the base plate (12) and the second substrate plate (20) is mounted to a second side of the first substrate plate (14, 14a, 14b).

4. The semiconductor module (10c, 10d) of claim 3,
wherein the second substrate plate (20) only covers a part of the first substrate plate (14, 14a, 14b).

5. The semiconductor module (10a, 10b, 10c, 10d) of one of the preceding claims, further comprising:
at least one terminal (24a, 24b, 24c) for electrically connecting the semiconductor module (10);
wherein the terminal (24a, 24b, 24c) is mounted to the second substrate plate (20).

6. The semiconductor module (10a, 10b, 10c, 10d) of one of the preceding claims,
wherein the first ceramics material is AlN; and/or
wherein the second ceramics material is Al2O3 or Si3N4.

7. The semiconductor module (10a, 10b, 10c, 10d) of one of the preceding claims,
wherein the first substrate plate (14, 14a, 14b) and the second substrate plate (20) are electrically connected via a flexible connector (26, 28, 30).

8. The semiconductor module (10a, 10c, 10d) of one of the preceding claims, further comprising:
at least one further first substrate plate (14, 14a, 14b), each further first substrate plate (14a, 14b, 14c) carrying at least one semiconductor chip (18).

9. The semiconductor module (10b) of one of the preceding claims, further comprising:
at least one further second substrate plate (20), each further second substrate plate (20) carrying at least one further terminal (24a, 24b, 24c).

10. A method for manufacturing a semiconductor module (10a, 10b, 10c, 10d), comprising:
providing a first insulating ceramics substrate plate (14, 14a, 14b) from a first ceramics material, which first insulating ceramics substrate plate (14, 14a, 14b) is at least partially covered with a metallization layer (16, 16');
bonding a semiconductor chip (18) to the first substrate plate (14, 14a, 14b);
providing a second insulating ceramics substrate plate (20) from a second ceramics material different from the first ceramics material, which second insulating ceramics substrate plate (20) is at least partially covered with a metallization layer (22, 22'); mounting the first substrate plate (14, 14a, 14b) to a base plate (12);
mounting the second substrate plate (20) to the base plate (12).

11. A method for manufacturing a semiconductor module (10c, 10d), comprising:
providing a first insulating ceramics substrate plate (14, 14a, 14b), which is at least partially covered with a metallization layer (16, 16');
bonding a semiconductor chip (18) to the first substrate plate (14, 14a, 14b);
providing a second insulating ceramics substrate plate (20), which second insulating ceramics substrate plate (20) is at least partially covered with a metallization layer (22, 22');
mounting the first substrate plate (14, 14a, 14b) with a first side to a base plate (12);
mounting the second substrate plate (20) to a second side of the first substrate plate (14, 14a, 14b).

12. The method of one of the claims 10 or 11, further comprising:
welding at least one terminal (24a, 24b, 24c) to the second substrate plate (20) before the second substrate plate (20) is mounted to the base plate (12) or to the first substrate plate (14, 14a, 14b).

13. The method of one of the claims 10 to 12, further comprising:
gluing the second substrate plate (20) to the base plate (12) or to the first substrate plate (14, 14a, 14b); or
bonding the second substrate plate (20) to the base plate (12) or to the first substrate plate (14, 14a, 14b).

14. The method of one of the claims 10 to 13, further comprising:
bonding the first substrate plate (14, 14a, 14b) to the base plate (12).

15. The method of claim 13 or 14,
wherein bonding is selected from: soldering, sintering, transient liquid phase bonding, low-temperature bonding.
